Europäisches Patentamt

European Patent Office

Office européen des brevets

(19)

(11) EP 1 494 078 A1

(12) EUROPEAN PATENT APPLICATION

(43) Date of publication:
05.01.2005 Bulletin 2005/01

(51) Int Cl.7: G03F 7/20

(21) Application number: 04076864.0

(22) Date of filing: 28.06.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 01.07.2003 EP 03077048

(71) Applicant: ASML Netherlands B.V.
5504 DR Veldhoven (NL)

(72) Inventors:
• Draaijer, Evert Hendrik Jan
5612 DC Eindhoven (NL)

• Cuijpers, Martinus Agnes Willem
5503 HG Veldhoven (NL)
• Fien, Menno
5052 BX Goirle (NL)
• Breukers, Marcus Joseph Elisabeth Godfried
5646 JA Eindhoven (NL)
• Houkes, Martijn
6135 HJ Sittard (NL)
• Van Donkelaar, Edwin Teunis
5313 SE Eindhoven (NL)

(74) Representative: Riemens, Roelof Harm
Exter Polak & Charlouis B.V.,
P.O. Box 3241
2280 GE Rijswijk (NL)

(54) **Lithographic apparatus and device manufacturing method.**

(57) A lithographic projection apparatus comprises an exposure system (2) and a measurement system (3). The exposure system projects a patterned beam onto a target portion of a first substrate (8), while the measurement system projects a measurement beam on a target portion of a second substrate (13). Movement of a movable part of the apparatus generates a disturbance in a position of another movable part of the apparatus, e.g. due to displacement of air. This error can be compensated by calculating a compensation signal which is a function of states of one or both of the movable parts.

Fig 1

## Description

The present invention relates to a lithographic apparatus comprising:

- a first movable part and a first control means for moving the first movable part,
- a second movable part and a second control means for moving the second movable part. Further, the invention relates to a device manufacturing method comprising:

- providing a first movable part and a first control means for moving the first movable part,
- providing a second movable part and a second control means for moving the second movable part.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a visco-elastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described here above, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as here above set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

A problem associated with the known lithographic projection apparatus and device manufacturing method mentioned above is that a movement of a movable part (e.g. of the measurement system) will influence a position of the other movable part (e.g. of the exposure system) and vice versa. As in general a resolution of the desired pattern is very high, and consequently accuracy requirements on the lithographic apparatus are very severe, a small disturbance might lead to a detoriation of the accuracy of the lithographic apparatus and/or to a detoriation in the production yield of the apparatus.

It is an object of the present invention to improve an accuracy of the lithographic apparatus and device manufacturing method.

This and other objects are achieved according to the invention in a lithographic apparatus as specified in the opening paragraph, characterized in that the lithographic apparatus further comprises

- correction determination means for determining a correction signal for at least partly correcting an error of a position of one of the first and the second movable parts, the error being caused by a movement of the other one of the first and second movable parts; and
- feeding means for feeding the correction signal into the first or second control means for at least partly correcting the position of the one of the first and the second movable parts. The inventor has devised that an error in the position of one of the movable parts is due to a movement of the other one of the movable parts due to a displacement of air caused by the movement of the other one of the movable parts. According to the invention, the error which results from the displacement of air is corrected, or at least partly corrected, by determining a correction signal and feeding the correction signal into the control means which control the position of the one, i. e. the disturbed of the movable parts.

The first and second movable parts are preferably movable with respect to each other in an uncorrelated manner, thus a movement of one of the movable parts not necessarily results in a movement of the other one of the movable parts having an opposite, compensating effect. Instead of the other one of the movable parts making a movement having an opposite effect, according to an aspect of the invention, the correction signal is determined for correcting the position of the disturbed one of the movable parts, and the correction signal is fed into the respective control means to correct the position of the disturbed movable part.

The invention is advantageously applied for correcting an error of a position of one of the movable parts, the error being caused by a displacement of air due to a movement of the other one of the movable parts. This allows a significant further reduction of remaining position errors in the position of the movable parts, as the correction of the position due to displacement of air is not left to the regular, existing control means (comprising e.g. a feedback loop) thus resulting in a residual error, but according to the invention a correction signal is determined and fed into the respective control means of the disturbed movable part.

The error advantageously comprises a position error, velocity error, acceleration error or other position related error.

The movable parts can comprise any movable part of the lithographic apparatus. More specifically, in a preferred embodiment, the movable part comprises a movable part of which a position related error, speed related error or acceleration related error results in an inaccuracy, reproduction error, scaling error, or other error of a lithographic projection to be created by the lithographic apparatus. The first and second control means can comprise dedicated hardware, such as an analogue electronic control system, however it is also possible that one or both of the control means are programmed in software which is executed by a processing means, such as a microprocessor dedicated for this function, or by processing means of the apparatus which also performs one or more other functions in the apparatus.

Advantageously, the lithographic apparatus further comprises an exposure system, the exposure system comprising:

- a radiation system for providing a projection beam of radiation;
- a support structure for supporting patterning means, the patterning means serving to pattern the projection beam according to a desired pattern;
- a substrate table for holding a first substrate;
- a projection system for projecting the patterned beam onto a target portion of the first substrate, the projection system comprising projection control means for controlling the projection onto the target position of the first substrate;

the first movable part being comprised in the exposure system, and the first control means being adapted for moving the first movable part such that the patterned beam is movable with respect to the first substrate. The movable part of the exposure system can for example be the projection system or part thereof, the substrate table for holding the first substrate, or any other suitable part, such that the patterned beam projected on a portion of the first substrate moves to another portion of the first substrate, when moving the movable part.

The lithographic apparatus in an advantageous embodiment further comprises a measurement system comprising:

- an optical measurement device for projecting a measurement beam on and for measuring a surface property of a target portion of a second substrate;
- a second substrate table for holding the second substrate;

the second movable part being comprised in the measurement system, and the second control means being adapted for moving the second movable part such that the measurement beam is movable with respect to the second substrate. The movable part in the measurement system can comprise the second substrate table or (a part of) the optical measurement device, or any other element, such that the target portion of the second substrate onto which the measurement beam is projected, displaces with respect to the substrate, when moving the movable part.

The optical measurement device advantageously serves to measure a surface property (such as a flatness) of the second substrate, to which end a measurement beam is projected in operation on a target portion of the second substrate.

It is possible that a correction signal is determined for at least partly correcting the position of the movable part of the exposure system, the error by a movement of the movable part of the optical measurement system, however it is also possible that an error in the position of the movable part of the measurement system is corrected or at least partly corrected, by means of the correction signal, the error by a movement of the movable part of the exposure system. Of course, it is also possible that both corrections are applied simultaneously, consecutively, or alternatingly.

It will be understood that the movable part of the exposure system and/or the measurement system can comprise a respective single movable part, however it is possible that one or both of the movable parts each comprises two or more movable subparts each moving in a same or a different (such as an opposite) direction. Also, it will be understood that the error could not only be caused by a displacement of air or other atmosphere or gas in which the apparatus is operating, but instead or in addition due to any other cause of transfer of the disturbance, such as by mechanical vibrations, etc.

The feeding means can e.g. comprise a signal to force converter for converting the correction signal into a correction force, however the feeding means can also comprise any other suitable means, such as an analogue or digital addition, subtraction etc. for combining the correction signal with any other suitable signal in the apparatus.

In a further preferred embodiment the lithographic apparatus comprises an actuator system comprising a long stroke actuator for moving an assembly of the apparatus in a displacement range and a short stroke actuator for moving the assembly in a subrange of the displacement range, the first movable part being comprised in the long stroke actuator, the second movable part being comprised in the short stroke actuator. In this manner, inaccuracies caused by a movement of one of the long and sort stroke actuator effecting the other one of the long and short stroke actuator can be at least partly compensated. The long stroke actuator advantageously serves as a coarse positioning means while the short stroke actuator serves as a fine positioning means, a total of the displacements by the short and long stroke actuator proving a total displacement by the actuator system. The actuator system can be comprised in any part of the lithographic apparatus, advantageously in the exposure system, benefitting from the advantageous effects such as increased accuracy as described above.

Advantageously, the correction determination means are adapted for determining the correction signal from states (such as mechanical states, positions, movements etc., or any combination thereof) of one or both of the movable parts.

Advantageously, the correction determination means are adapted for calculating the correction signal from information, preferably an acceleration, of the other one of the movable parts, and a distance between the movable parts. The inventor has devised that the influence on the one of the movable parts caused by a movement of the other one of the movable parts decreases when the distance between these parts increases, and that the disturbance, and thus the error is related to the acceleration of the movable parts. With this advantageous embodiment a good estimate of the disturbance, and thus a suitable value of the correction signal can be determined.

Advantageously, the information comprises the acceleration, the acceleration being provided by an acceleration detector comprised in the first or second control means (e.g. comprised in the other one of the exposure system and the measurement system) and wherein the distance which is calculated from the respective positions of the movable parts, the respective positions being provided by respective position detectors. Thus, little or no additional hardware in the apparatus is required as acceleration information and position information from detectors already present in the system can be applied for calculating the correction signal.

Advantageously, an x axis and a y axis being defined in a plane in which the first and second movable parts are movable, the correction determination means being adapted for determining an x-correction signal for correcting an error in the position of the one of the first and second movable parts along the x-axis from an x-axis component of the information and for determining an y-correction signal for correcting an error in the position of the one of the first and second movable parts along the y-axis from an y-axis component of the information. A movement of the other one of the movable parts in a certain direction will result in an error caused by displacement of air in the same direction, which can thus be corrected.

Advantageously, the control-means are adapted for calculating the correction signal making use of the formula

$$F_{x,y} = \frac{C^* \, Acc_{x,y}}{D^2_{xy}}$$

wherein $F_{x,y}$ is the correction signal in x and y direction respectively, C is a constant, $Acc_{x,y}$ is the acceleration in x and y direction respectively, and $D_{xy}$ is the distance between the first and second movable parts. The constant C can be identical for the correction in the x direction and the y direction, however it is also possible that different values for the constant C are applied.

Advantageously, the correction determination means being adapted for determining an x to y-correction signal for correcting an error in the position of the one of the first and second movable parts along the x-axis from an y-axis component of the information and for determining an y to x-correction signal for correcting an error in the position of the one of the first and second movable parts along the y-axis from an x-axis component of the information. In this manner, a more accurate correction can be achieved, as a movement of one of the movable parts in the x or y direction will also result in a correction of the other one of the movable parts in the other (thus the y or x) direction.

Advantageously, the control means are adapted for calculating the x to y- or y to x-correction signal making use of the formula

$$F_{x \, to \, y, \, y \, to \, x} = \frac{C * D_x * Acc_{x,y}}{D^2_y}$$

wherein $F_{x \, to \, y, \, y \, to \, x}$ is the x to y and the y to x correction signal respectively, C is a constant, $Acc_{x,y}$ is the acceleration in x and y direction respectively, $D_x$ is the distance between the first and second movable parts in x direction, and $D_y$ is the distance between the first and second movable parts in y direction. Also in this situation, the constant C can have different values for the x to y and the y to x correction, however can have also have identical values for these two corrections, and the value of the constant C can be identical of different to the value(s) of the constant C for calculating the $F_{x,y}$ correction signal.

The apparatus and in particular the feeding means can comprise a delay for delaying the or each correction signal, such that delays due to digital processing applied in the control means can be taken into account.

Advantageously, the feeding means are adapted for adding the or each correction signal to a control signal, such as a position signal, at an output of a regulator in a closed loop feedback control loop. As the output of the control is connected to a control input of a positioning device for displacing the movable part, the correction signal is added at a place in the control loop the most similar to the place where the disturbance too is acting, thus resulting in a good compensation of the error.

The method according to the invention is characterized by

- determining a correction signal for at least partly correcting an error of a position of one of the first and the second movable parts, the error being caused by a movement of the other one of the first and second movable parts; and
- feeding the correction signal into the first or second control means for at least partly correcting the position of the one of the first and the second movable parts.

In and advantageous embodiment, the method further comprises:

- providing a first substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material,
- moving the patterned beam with respect to the first substrate;
- providing a second substrate;
- projecting a measurement beam on and measuring a surface property of a target portion of the second substrate;
- moving the measurement beam with respect to the second substrate. Thus, a correction signal is determined for at least partly correcting an error of a position of one of the patterned beam and the measurement beam with respect to the respective one of the first and second substrates, the error by a movement of a device for moving the other one of the patterned beam and the measurement beam with respect to the other one of the first and second substrates, and the position of the one of the patterned beam and the measurement beam is corrected with respect to the respective first or second substrate with the correction signal.

It will be clear to the skilled person that advantageous embodiments as described above with reference to the apparatus according to the invention, can also be applied to the method according to the invention. The advantages and effects as described with reference to the apparatus according to the invention are also applicable to the method according to the invention.

The compensation according to the invention can not only be applied for compensating an error due to a movement of a movable part of e.g. the other one of the measurement system and the exposure system, but can be applied for compensating a disturbance caused by any other movable part of the apparatus.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:

- Figure 1 schematically depicts a lithographic projection apparatus according to an embodiment of the invention;
- Figure 2 schematically depicts a top view of movable parts of the exposure system and the measurement system;
- Fig. 3 schematically depicts a close loop control loop for controlling a position of one of the movable parts of the apparatus according to the invention; and
- Fig. 4 shows a flow diagram of the method according to the invention.

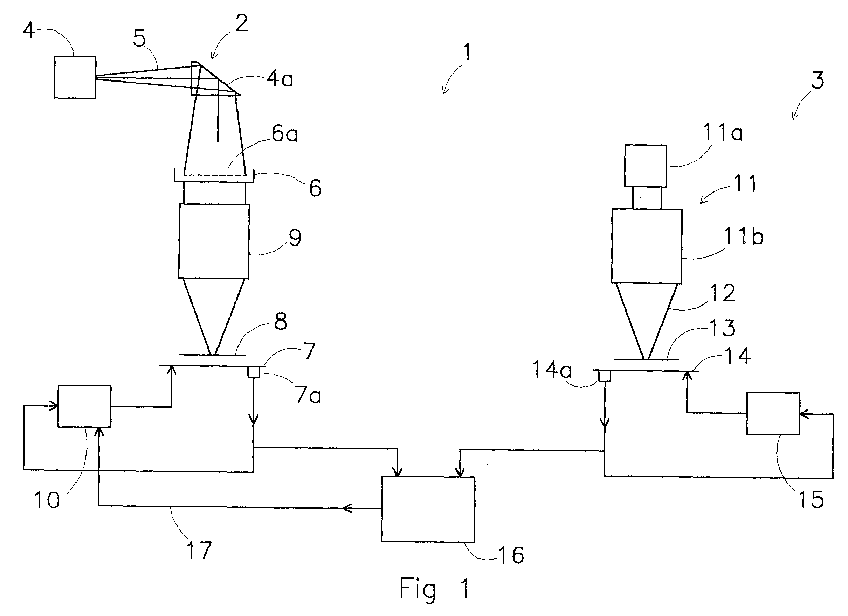

The lithographic projection apparatus as depicted in fig. 1 comprises an exposure system 2 and a measurement system 3. The exposure system 2 comprises a radiation system 4, such as a light source for generating a projection beam of radion 5 and a prism (or other deflection means) 4a, a support structure for the patterning means 6a, such as a reticle, a substrate table 7 for holding a first substrate 8, and a projection system 9 for projecting the patterned beam onto a target portion of the second substrate 13. The optical measurement device can for example comprise a radiation system 11a, a projection system 11b and further elements (not shown) for measuring a surface property of the target portion of the second substrate 13 by means of reflection, a geometric change, absorption, diffraction or any other physical phenomena due to the projection of the measurement beam 12 on the target portion of the second substrate 13. The measurement system 2 further comprises a second substrate table 14 for holding the second substrate 13 and second control means 15 for moving at least a part of the measurement system 2, such that the measurement beam is movable over the substrate 13. The exposure system 2 exposes target portions of the first substrate and thus projects the pattern provided by the patterning means 6c onto the first substrate 8. In this embodiment, the substrate table 7 is moved under control of the first control means 10, such that the patterned beam moves with respect to the first substrate 8, thus providing the possibility for scanning the first substrate and exposing each desired part of the first substrate. Simultaneously to the movement of the movable part of the exposure system 2 (the movable part in this example being the substrate 8) the measurement system 3 measures a surface property, such as a flatness of a second substrate 13. As the surface property of a relevant part of the second substrate is to be measured, a scanning movement of the measurement beam 12 with respect to the second substrate 13 is accomplished, as explained above by moving the second substrate 13 and the correction beam 12 with respect to each other.

With the lithographic projection apparatus 1, exposing a first substrate 8 and measuring a second substrate 13 (the substrates for example being semiconductor wafers), can be performed simultaneously. Each of the movable parts, in this example the substrate table 7 and the substrate table 14, is controlled by respective control means 10, 15 controlling a position of the respective substrate table 7, 14. The control means 10, 15 each form a close loop control circuit with respective position detection means 7a, 14a, such as position sensors, acceleration sensors, etc. The structure of the first and second control means will be explained in more detail below. The system further comprises correction determination means 16 for determining a correction signal. The correction signal is fed via feeding means 17 into the first control means 10. The correction determination means 16 are supplied with position information regarding a position of the first and second substrate table, the position information being supplied by the respective position sensors 7a and 14a of the first and second substrate tables 7 and 14. The calculation determination means calculate a correction signal from the information provided by the sensors 7a and 14a. The correction signal provides a correction for a disturbance and consequently a position error in the exposure system which is caused by a movement of the movable part (in this example the movable substrate table 14) of the measurement system 3. Due to the movement of the movable parts, pressure waves in air surrounding the respective movable parts are generated, which pressure waves tend to cause disturbances in the other system (in this example the exposure system 2). Although the error caused by such air displacement might at first sight be small in absolute terms, and be in an order of magnitude of nanometers or micrometers, it might lead to a significant error in the system which is influenced, as accuracy requirements of the projection apparatus 1 are in general high. The correction determination means 16 in this embodiment calculate the correction signal from an acceleration of the movable part of the measurement system (i.e. the second table 14) and a distance between the respective movable parts, i.e. in this example the first and second substrate tables 7 and 14. Thus, in this example, the sensor 14a comprises an acceleration sensor for measuring an acceleration of the substrate table 14 as well as position sensors for detecting a position of the second substrate table 14. The sensor 7a in this example comprises at least a position sensor for detecting the position of the first substrate table 7. Consequently, the position of both substrate tables 7 and 14 as well as the acceleration of the second substrate table 14 is provided to the correction determination means. From the positions of the first and second substrate tables 7 and 14 a distance between these substrate tables is calculated by the correction determination means 16, the distance being applied for calculating the correction signal. In this example, the correction signal is calculated making use of the formula

$$F = \frac{C^* \, Acc}{D^2}$$

wherein F is the correction signal, C is constant, Acc is the acceleration and D is the distance between the movable parts of the exposure system and de measurement system. In this example, a position of a movable part of the exposure system is corrected, thus Acc being the acceleration of the other movable part, thus the movable part of the measurement system.

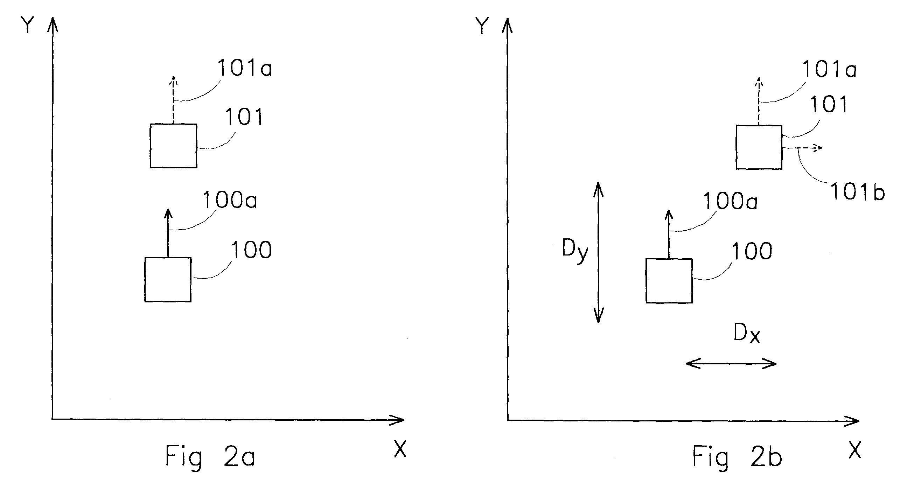

Fig. 2a and fig. 2b highly schematically show a top view of a movable part 100 of a measurement system and a movable part 101 of an exposure system. Fig. 2a as well as fig. 2b also show a coordinate system comprising an x axis and an y axis. The x axis and y axis are defined in a plane in which the movable parts 100 and 101 are movable. When the movable part 100 makes a movement indicated with the arrow 100a, displacement of air will cause a disturbance on the second movable part 101 acting in a direction indicated by the dotted arrow 101a. According to the invention, a correction signal is calculated by the correction determination means which at least partly counteract an influence of the disturbance 101a. For this calculation, in the embodiment described, the following formula is used:

$$F_{x,\,y} = \frac{C \, * \, Acc_{x,y}}{D^2_{\,xy}}$$

wherein $F_{x,y}$ is the correction signal in x and y direction respectively, C is a constant, $Acc_{x,y}$ is the acceleration in x and y direction respectively, and $D_{xy}$ is the distance between the movable parts of the exposure system and the measurement system.

In fig. 2b, the displacement of the movable part 100, which is schematically indicated by the 100a causes a pressure wave in the surrounding air which influences the movable part 101 and causes a disturbance indicated by the arrows 101a and 101b. The disturbance indicated by the arrow 101a is in the direction of the y axis, while the disturbance indicated by the arrow 101b is in the direction of the x axis. Thus, the displacement 100a which is in the direction of the y axis causes a disturbance of the movable part 101 in the direction of the x axis as well as the direction of the y axis. In this example, this is due to the offset in the direction in the x axis between the movable parts 100 and 101, however might be due to any other cause, such as geometry of the surrounding, etc. The correction determination means are adapted for calculating the correction signal comprising a component for at least partly compensating the disturbance 101a in the y direction and a component for at least partly compensating the disturbance 101b in the x direction. In this embodiment, the respective components of the correction signal are calculated making use of the formula:

$$F_{x\ to\ y,\ y\ to\ x} = \frac{C * D_x * Acc_{x,y}}{D^2_y}$$

wherein $F_{x\ to\ y,\ y\ to\ x}$ is the x to y and the y to x correction signal respectively, C is a constant, $Acc_{x,y}$ is the acceleration in x and y direction respectively, $D_x$ is the distance between the movable parts of the exposure system and the measurement system in x direction, and $D_y$ is the distance between the movable parts of the exposure system and the measurement system in y direction. Thus $F_{x\ to\ y}$ represents a correction in the y direction due to a movement of the other movable part in the x direction and vice versa. The distances $D_x$ and $D_y$ are indicated in fig. 2b.. Thus, when the distance $D_x$ in x direction is zero, as depicted in fig. 2a, a calculation of the x to y and y to x compensation will result in a correction having a value zero, while the larger the distance $D_x$ (fig, 2b as compared to fig. 2a), the larger the x to y- and/or y to x-compensation signal will be.

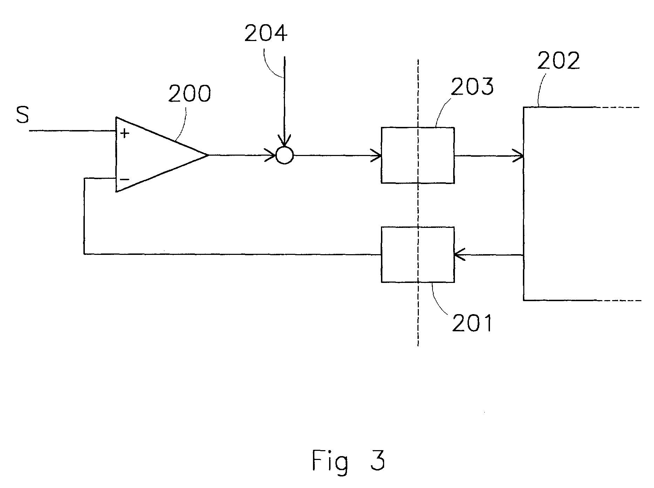

Fig. 3 shows a more detailed schematic representation of a closed loop control loop comprising the first control means 10 as depicted in fig. 1. The first control means comprise a regulator 200 having two inputs. A first input of the regulator 200 is connected to a set point signal S which provides a set point, i.e. a signal representing a desired position of the movable part. The other input of the regulator 200 is connected to a sensor, 201, such as a position sensor or an acceleration sensor which detects a position or acceleration of the movable part 202. The movable part, of which only a highly schematically depicted part is shown, is positioned by positioning means 203, such as an actuator. The positioning means 203 are driven by an output signal of the regulator 200. The regulator 200 can for example be an analogue electronic regulator, however it is also possible that the regulator 200 is implemented by means of suitable software instructions running on a microprocessor or a microcomputer. The regulator 200 can comprise integration, proportional regulation, differentiation or any suitable operations. The dotted line which crosses the positioning means 203 and the sensor 201 represents a separation between an "electronic" or "control" part and a "physical" part. The increase of a disturbance due to displacement of another movable part of the projection apparatus, air pressure fluctuations or pressure waves caused by this displacement will result in a disturbance of the movable part 202. To (at least partly) compensate for the disturbance of the movable part 202, a compensation signal 204 is added to the output signal of the regulator 200, thus feeding the correction signal into the control loop. If the control means comprise a digital regulator, comprising dedicated hardware or programmed in software, than the feeding means for feeding the correction signal into the control means for example comprise a digital addition of subtraction implemented in either hardware or software, however it is also possible that the feeding means comprise any other suitable means for feeding the correction signal into the respective control means, such as an analogue addition adding a voltage or a current, any suitable means, or any other way of feeding the correction signal into the control means. In case that the first and/or second control means comprise digital control means, the feeding means according to this embodiment comprise a delay for delaying the correction signal. The delay in this example matches a delay of the digital control means, such that adverse effects due to for example a to early compensation by the correction signal are largely eliminated; thus the feeding means add the correction signal to a control signal at the output of the regulator in the closed loop control.

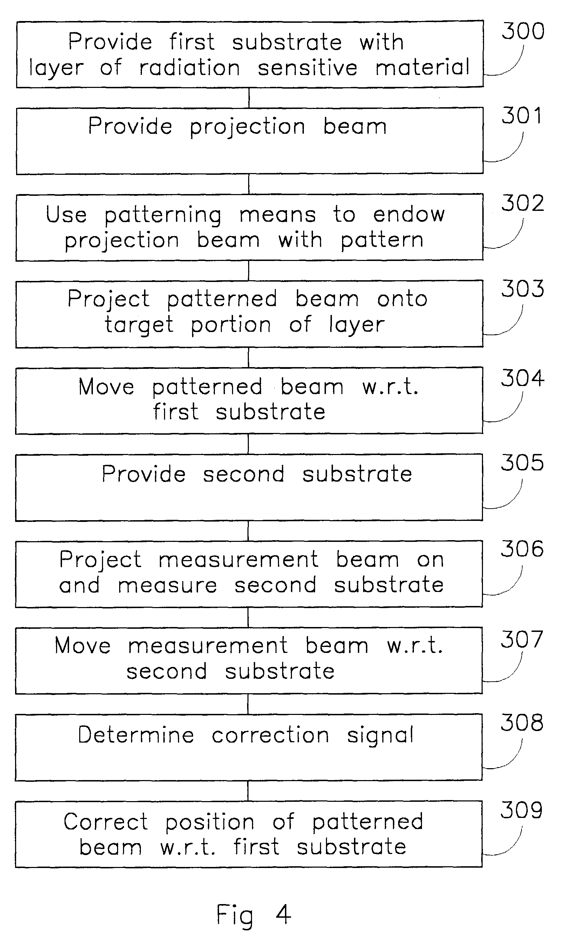

Fig. 4 shows the device manufacturing method according to the invention. In step 300, a first substrate is provided. The first substrate is at least partly covered by a layer of radiation-sensitive material. Then, in step 301 a projection beam is provided using a radiation system. In step 302, pattern means are used to endow the projection beam with a pattern in its cross-section. In step 303, the patterned beam is projected onto a target potion of the layer of radiation-sensitive material on the first substrate. In step 304 the patterned beam is moved with respect to the first substrate. In step 305 a second substrate is provided while in step 306 a measurement beam is projected on a target portion of the second substrate and a surface property of the target portion of de second substrate is measured. Then, in step 307, the measurement beam is moved over a relevant portion of the surface of the second substrate. By moving the respective beams with respect to the respective substrates, the respective beam can move with respect to, such as scan, a relevant portion of the respective substrate. Thus, the patterned beam scans a relevant portion of the first substrate while the measurement beam scans a relevant portion of the second substrate. In step 308 a correction signal is determined for at least partly correcting an error of a position of the patterned beam on the first substrate, the error by a movement of a device for moving the measurement beam with respect to the second substrate. Of course, it is also possible that step 308 comprises the step of determining a correction signal for at least partly correcting an error of a position of the measurement beam on the second substrate, the error by a movement of a device for moving the patterned beam with respect to the first substrate. In step 309, the position of the patterned beam with respect to the first substrate is corrected with the correction signal. It will be clear that it is also possible that in step 308 the position of the measurement beam with respect to the second substrate is corrected with the correction signal. Further, it will be clear to the skilled person that one or more steps or parts of the steps or all steps can be performed simultaneously, consecutively of in any suitable order.

Thus, according to the invention a compensation is provided for compensating an error caused by a displacement of air due to a movement of a movable part of a lithographic system, the error being caused by displacement of air or pressure waves in the air due to a movement of another movable part of the lithographic apparatus. The compensation is calculated based on the acceleration of the movable part which causes the disturbance, and the distance (more preferably the inverse of the square distance) between the respective movable parts.

From the remainder of this application, it will be clear to the skilled person that the invention is not intended to be limited to examples as described above, but also applies to any movable part in the lithographic apparatus resp. the device manufacturing method according to the invention.

An embodiment of the invention can also be worded as a lithographic projection apparatus comprising an exposure system and a measurement system, the exposure system comprising:

- a radiation system for providing a projection beam of radiation;
- a support structure for supporting patterning means, the patterning means serving to pattern the projection beam according to a desired pattern;
- a substrate table for holding a first substrate;
- a projection system for projecting the patterned beam onto a target portion of the first substrate, the projection system comprising projection control means for controlling the projection onto the target position of the first substrate; and
- first control means for moving a movable part of the exposure system such that the patterned beam is movable with respect to the first substrate,

the measurement system comprising:

- an optical measurement device for projecting a measurement beam on and for measuring a surface property of a target portion of a second substrate;
- a second substrate table for holding the second substrate; and
- second control means for moving a movable part of the measurement system such that the measurement beam is movable with respect to the second substrate,

characterized in that
the apparatus further comprises

- correction determination means for determining a correction signal for at least partly correcting an error of a position of the movable part of one of the exposure system and the measurement system, the error by a movement of the movable part of the other one of the exposure system and the measurement system, and
- feeding means for feeding the correction signal into the first or second control means for at least partly correcting the position of the one of the exposure system and the measurement system.

Similarly, in an embodiment, the method according to the invention can also be worded as a device manufacturing method comprising the steps of:

- providing a first substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material,
- moving the patterned beam with respect to the first substrate;
- providing a second substrate;
- projecting a measurement beam on and measuring a surface property of a target portion of the second substrate;
- moving the measurement beam with respect to the second substrate;

characterized by the steps of:

- determining a correction signal for at least partly correcting an error of a position of one of the patterned beam and the measurement beam with respect to the respective one of the first and second substrates, the error by a movement of a device for moving the other one of the patterned beam and the measurement beam with respect to the other one of the first and second substrates; and

- correcting the position of the one of the patterned beam and the measurement beam with respect to the respective first or second substrate with the correction signal.

Whilst specific embodiments of the invention have been described above, it will be appreciated that the invention may be practiced otherwise than as described. The description is not intended to limit the invention.

**Claims**

1. A lithographic apparatus comprising:

   - a first movable part and a first control means for moving the first movable part,
   - a second movable part and a second control means for moving the second movable part,

   **characterized in that** the lithographic apparatus further comprises

   - correction determination means for determining a correction signal for at least partly correcting an error of a position of one of the first and the second movable parts, the error being caused by a movement of the other one of the first and second movable parts; and
   - feeding means for feeding the correction signal into the first or second control means for at least partly correcting the position of the one of the first and the second movable parts.

2. The lithographic projection apparatus according to claim 1, further comprising an exposure system, the exposure system comprising:

   - a radiation system for providing a projection beam of radiation;
   - a support structure for supporting patterning means, the patterning means serving to pattern the projection beam according to a desired pattern;
   - a substrate table for holding a first substrate;
   - a projection system for projecting the patterned beam onto a target portion of the first substrate, the projection system comprising projection control means for controlling the projection onto the target position of the first substrate;

   the first movable part being comprised in the exposure system, and the first control means being adapted for moving the first movable part such that the patterned beam is movable with respect to the first substrate.

3. The lithographic apparatus according to claim 2, further comprising a measurement system comprising:

   - an optical measurement device for projecting a measurement beam on and for measuring a surface property of a target portion of a second substrate;
   - a second substrate table for holding the second substrate;

   the second movable part being comprised in the measurement system, and the second control means being adapted for moving the second movable part such that the measurement beam is movable with respect to the second substrate.

4. The lithographic apparatus according to claim 1 or 2, comprising an actuator system comprising a long stroke actuator for moving an assembly of the apparatus in a displacement range and a short stroke actuator for moving the assembly in a subrange of the displacement range, the first movable part being comprised in the long stroke actuator, the second movable part being comprised in the short stroke actuator.

5. The lithographic apparatus according to claim 4, wherein the actuator system is comprised in the exposure system.

6. The lithographic apparatus according to any of the preceding claims, wherein the correction determination means are adapted for determining the correction signal from states of one or both of the movable parts.

7. The lithographic apparatus according to any of the preceding claims, wherein the correction determination means are adapted for calculating the correction signal from information, preferably an acceleration, of the other one of the movable parts, and a distance between the movable parts.

8. The lithographic apparatus according to claim 7, wherein the information comprises the acceleration, the acceleration being provided by an acceleration detector comprised in the first or second control means and wherein the distance is calculated from respective positions of the movable parts, the respective positions being provided by respective position detectors.

9. The lithographic apparatus according to claim 7 or 8, wherein an x axis and a y axis being defined in a plane in which the first and second movable parts are movable, the correction determination means being adapted for determining an x-correction signal for correcting an error in the position of the movable part of the one the of first and second movable parts along the x-axis from an x -axis component of the information and for determining an y-correction signal for correcting an error in the position of the one of the first and second movable parts along the y-axis from an y-axis component of the information.

10. The lithographic apparatus according to claim 9, wherein the control means are adapted for calculating the correction signal making use of the formula

$$F_{x,y} = \frac{C * Acc_{x,y}}{D^2_{xy}}$$

wherein $F_{x,y}$ is the correction signal in x and y direction respectively, C is a constant, $Acc_{x,y}$ is the acceleration in x and y direction respectively, and $D_{xy}$ is the distance between the first and second movable parts.

11. The lithographic apparatus according to claim 9 or 10, wherein the correction determination means being adapted for determining an x to y-correction signal for correcting an error in the position of the one of the first and second movable parts along the x-axis from an y-axis component of the information and for determining an y to x-correction signal for correcting an error in the position of the one of the first and second movable parts along the y-axis from an x-axis component of the information.

12. The lithographic apparatus according to claim 11, wherein the control means are adapted for calculating the x to y- or y to x-correction signal making use of the formula

$$F_{x \text{ to } y, y \text{ to } x} = \frac{C * D_x * Acc_{x,y}}{D^2_y}$$

wherein $F_{x \text{ to } y, y \text{ to } x}$ is the x to y and the y to x correction signal respectively, C is a constant, $Acc_{x,y}$ is the acceleration in x and y direction respectively, $D_x$ is the distance between the movable parts in x direction, and $D_y$ is the distance between the movable parts in y direction.

13. The lithographic apparatus according to any of the preceding claims, wherein the feeding means comprise a delay for delaying the or each correction signal.

14. The lithographic apparatus according to any of the preceding claims, wherein the feeding means are adapted for adding the or each correction signal to a control signal at an output of a regulator in a closed loop feedback control loop.

15. A device manufacturing method comprising:

- providing a first movable part and a first control means for moving the first movable part,
- providing a second movable part and a second control means for moving the second movable part,

**characterized by**

- determining a correction signal for at least partly correcting an error of a position of one of the first and the second movable parts, the error being caused by a movement of the other one of the first and second movable parts; and
- feeding the correction signal into the first or second control means for at least partly correcting the position of the one of the first and the second movable parts.

16. The device manufacturing method according to claim 15, further comprising:

- providing a first substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material,
- moving the patterned beam with respect to the first substrate;
- providing a second substrate;
- projecting a measurement beam on and measuring a surface property of a target portion of the second substrate;
- moving the measurement beam with respect to the second substrate.

Fig 1

Y

101a

101

100a

100

Fig 2a

X

EP 1 494 078 A1

Y

101a

101

101b

$D_y$

100a

100

$D_x$

Fig 2b

X

Fig 3

| Provide first substrate with layer of radiation sensitive material | 300 |
|---|---|
| Provide projection beam | 301 |
| Use patterning means to endow projection beam with pattern | 302 |
| Project patterned beam onto target portion of layer | 303 |
| Move patterned beam w.r.t. first substrate | 304 |
| Provide second substrate | 305 |
| Project measurement beam on and measure second substrate | 306 |
| Move measurement beam w.r.t. second substrate | 307 |
| Determine correction signal | 308 |
| Correct position of patterned beam w.r.t. first substrate | 309 |

Fig 4

**European Patent Office**

## EUROPEAN SEARCH REPORT

Application Number

EP 04 07 6864

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 557 100 A (CANON KK) 25 August 1993 (1993-08-25) * page 4, line 20 – page 5, line 38 * * figures 4-6 * | 1-8, 13-16 | G03F7/20 |
| X | EP 1 186 959 A (ASM LITHOGRAPHY BV) 13 March 2002 (2002-03-13) * paragraph '0008! – paragraph '0010! * * paragraph '0023! – paragraph '0029! * | 1-5,15, 16 | |

TECHNICAL FIELDS SEARCHED (Int.Cl.7)

G03F

The present search report has been drawn up for all claims

| Place of search | Date of completion of the search | Examiner |
|---|---|---|
| The Hague | 1 October 2004 | Aguilar, M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 07 6864

This annex lists the patent family members relating to the patent documents cited in the above—mentioned European search report.
The members are as contained in the European Patent Office EDP file on
The European Patent Office is in no way liable for these particulars which are merely given for the purpose of information.

01-10-2004

| Patent document cited in search report | | Publication date | Patent family member(s) | | Publication date |
|---|---|---|---|---|---|
| EP 0557100 | A | 25-08-1993 | JP | 3202308 B2 | 27-08-2001 |
| | | | JP | 5234865 A | 10-09-1993 |
| | | | JP | 5250041 A | 28-09-1993 |
| | | | DE | 69322983 D1 | 25-02-1999 |
| | | | DE | 69322983 T2 | 15-07-1999 |
| | | | EP | 0557100 A1 | 25-08-1993 |
| | | | US | 5504407 A | 02-04-1996 |
| EP 1186959 | A | 13-03-2002 | EP | 1186959 A2 | 13-03-2002 |
| | | | JP | 2002158168 A | 31-05-2002 |
| | | | TW | 497013 B | 01-08-2002 |
| | | | US | 2002026878 A1 | 07-03-2002 |

EPO FORM P0459